# EUROPEAN PATENT APPLICATION

(11) **EP 4 583 148 A1**
(43) Date of publication of application: **09.07.2025**
(21) Application number: 23860004.3
(22) Date of filing: 10.08.2023
(51) Int. Cl.: H01L 21/02

(54) **SEMICONDUCTOR SUBSTRATE AND METHOD FOR MANUFACTURING SEMICONDUCTOR SUBSTRATE**

(30) Priority: 29.08.2022 JP 2022135772
(71) Applicant: Sicoxs Corporation, Minato-ku Tokyo 1050004 (JP)
(72) Inventor: UCHIDA, Hidetsugu, Tokyo 105-0004 (JP)
(74) Representative: TBK
(86) International application number: PCT/JP2023/029247
(87) International publication number: WO 2024/048239

(57) **Abstract**

Provided are a semiconductor substrate capable of preventing occurrence of interface resistance at a bonded interface, and a method for manufacturing a semiconductor substrate.

A method for manufacturing a semiconductor substrate includes: a damaged layer formation step of forming a damaged layer in at least one of a first bonding target surface of a first semiconductor substrate and a second bonding target surface of a second semiconductor substrate; a specific element introduction step of introducing a specific element into at least one of the first bonding target surface and the second bonding target surface; a bonding step of bonding the first bonding target surface and the second bonding target surface together to form a bonded semiconductor substrate having a bonded interface; and a thermal treatment step of subjecting the bonded semiconductor substrate to a thermal treatment, in which the thermal treatment step is a step of causing the specific element introduced into at least one of the first semiconductor substrate and the second semiconductor substrate to move into the damaged layer.

## Description

### Technical Field

The present invention relates to a semiconductor substrate and a method for manufacturing a semiconductor substrate, and particularly to a semiconductor substrate capable of preventing occurrence of interface resistance at a bonded interface in a bonded semiconductor substrate in which two or more substrates are bonded via the bonded interface by bonding, and a method for manufacturing a semiconductor substrate.

### Background Art

As an example of manufacturing a bonded semiconductor substrate, a technique of bonding a SiC single crystal and a SiC polycrystal is known. Note that, as a related technique, for example, a technique disclosed in Patent Literature 1 is known.

### Citation List

### Patent Literature

Patent Literature 1: JP 6387375 B2

### Summary of Invention

### Technical Problem

However, when the SiC single crystal and the SiC polycrystal are directly bonded to each other, electric resistance (interface resistance) at a bonded interface may increase. In this case, when a device in which a current path is formed so as to cross the bonded interface is produced, device characteristics are affected, which is not preferable.

Therefore, in order to solve the above problems, an object of the present invention is to provide a semiconductor substrate capable of preventing occurrence of interface resistance at a bonded interface, and a method for manufacturing a semiconductor substrate.

### Solution to Problem

In order to solve the above problems, a method for manufacturing a semiconductor substrate of the present invention is a method for manufacturing a semiconductor substrate including a first semiconductor substrate and a second semiconductor substrate, the method including: a damaged layer formation step of forming a damaged layer in at least one of a first bonding target surface of the first semiconductor substrate and a second bonding target surface of the second semiconductor substrate; a specific element introduction step of introducing a specific element into at least one of the first bonding target surface and the second bonding target surface; a bonding step of bonding the first bonding target surface and the second bonding target surface together to form a bonded semiconductor substrate having a bonded interface after the damaged layer formation step and after the specific element introduction step; and a thermal treatment step for subjecting the bonded semiconductor substrate to a thermal treatment, in which the thermal treatment step is a step of causing the specific element introduced into at least one of the first semiconductor substrate and the second semiconductor substrate to move into the damaged layer of the first semiconductor substrate or the damaged layer of the second semiconductor substrate, a pentavalent element is used as the specific element when the first semiconductor substrate and the second semiconductor substrate are N-type semiconductors, and a trivalent element is used as the specific element when the first semiconductor substrate and the second semiconductor substrate are P-type semiconductors.

The first semiconductor substrate and the second semiconductor substrate may be any one of silicon carbide (SiC), silicon (Si), carbon (C), gallium nitride (GaN), aluminum nitride (AlN), gallium oxide (Ga₂O₃), and diamond.

The specific element introduction step may be performed after the damaged layer formation step, or the damaged layer formation step may be performed after the specific element introduction step.

At least one of silicon (Si), carbon (C), helium (He), neon (Ne), argon (Ar), xenon (Xe), hydrogen (H), nitrogen (N), phosphorus (P), boron (B), and aluminum (Al) may be present in the damaged layer.

The damaged layer formation step may be a step of forming the damaged layer by performing at least one treatment of ion implantation, neutral element implantation, and plasma irradiation with respect to at least one of the first bonding target surface and the second bonding target surface.

The specific element introduction step may be a step of introducing the specific element by performing at least one treatment of ion implantation, neutral element implantation, plasma doping, and thermal diffusion with respect to at least one of the first bonding target surface and the second bonding target surface.

The specific element may be at least one of nitrogen (N), phosphorus (P), boron (B), and aluminum (Al).

A thermal treatment temperature in the thermal treatment step may be 1100°C to 2200°C.

The method for manufacturing a semiconductor substrate of the present invention may include an irradiation step of irradiating at least one of the first bonding target surface and the second bonding target surface with an argon beam after the damaged layer formation step and after the specific element introduction step and before the bonding step.

In the method for manufacturing a semiconductor substrate of the present invention, the first semiconductor substrate is a SiC polycrystal substrate and the second semiconductor substrate is a SiC single crystal substrate, the first semiconductor substrate is a Si substrate and the second semiconductor substrate is a Si substrate, the first semiconductor substrate is a gallium nitride (GaN) substrate and the second semiconductor substrate is a gallium nitride (GaN) substrate, the first semiconductor substrate is a gallium oxide (Ga₂O₃) substrate and the second semiconductor substrate is a gallium oxide (Ga₂O₃) substrate, or the first semiconductor substrate is a diamond substrate and the second semiconductor substrate is a diamond substrate, and the method may include a hydrogen ion implantation step of implanting hydrogen ions into the second bonding target surface before the damaged layer formation step and before the specific element introduction step.

The method for manufacturing a semiconductor substrate of the present invention may include a peeling step of peeling the second semiconductor substrate using a microbubble layer as a peeling surface after the bonding step and before the thermal treatment step.

In order to solve the above problems, a semiconductor substrate of the present invention is a semiconductor substrate including: a first semiconductor substrate; and a second semiconductor substrate bonded to the first semiconductor substrate via a bonded interface, in which a concentration of a specific element in the semiconductor substrate is the highest in at least any region of the bonded interface and a region from the bonded interface to a vicinity of 15 nm.

The concentration of the specific element at the bonded interface may be 1.0×10¹⁹ atoms/cm³ to 2.0×10²⁰ atoms/cm³.

The specific element in the semiconductor substrate may have a high concentration in at least one of the bonded interface and a region from the bonded interface to a vicinity of 15 nm and in a region 40 nm to 60 nm away from the bonded interface.

The first semiconductor substrate and the second semiconductor substrate may be any one of silicon carbide (SiC), silicon (Si), carbon (C), gallium nitride (GaN), aluminum nitride (AlN), gallium oxide (Ga₂O₃), and diamond.

The semiconductor substrate of the present invention may include a damaged layer in at least one of the bonded interface and a region from the bonded interface to a vicinity of 15 nm, in which at least one of silicon (Si), carbon (C), helium (He), neon (Ne), argon (Ar), xenon (Xe), hydrogen (H), nitrogen (N), phosphorus (P), boron (B), and aluminum (Al) may be present in the damaged layer.

The specific element may be at least one of nitrogen (N), phosphorus (P), boron (B), and aluminum (Al).

The semiconductor substrate of the present invention may be the semiconductor substrate in which the first semiconductor substrate is a SiC polycrystal substrate, the second semiconductor substrate is a SiC single crystal substrate, and a concentration of phosphorus at the bonded interface is 1.0×10¹⁹ atoms/cm³ to 2.0×10²⁰ atoms/cm³.

### Advantageous Effects of Invention

According to the present invention, it is possible to provide a semiconductor substrate capable of preventing occurrence of interface resistance at a bonded interface, and a method for manufacturing a semiconductor substrate.

### Brief Description of Drawings

Fig. 1 is a flowchart illustrating an example of a method for manufacturing a semiconductor substrate of the present invention.
Fig. 2 is a perspective view illustrating an example of a semiconductor substrate of the present invention.
Fig. 3 is a schematic side view of a second semiconductor substrate in the present invention.
Fig. 4 is a schematic side view of the second semiconductor substrate in the present invention.
Fig. 5 is an explanatory view illustrating an example of an irradiation step in the present invention.
Fig. 6 is a schematic side view illustrating an example of the semiconductor substrate of the present invention.
Fig. 7 is a schematic side view illustrating an example of the semiconductor substrate of the present invention.
Fig. 8 is a graph showing phosphorus concentration profiles at a bonded interface and in the vicinity of the bonded interface after a peeling step and after a thermal treatment step.
Fig. 9 is a view illustrating a conduction mechanism model.
Fig. 10 is a cross-sectional view of a characteristic ON resistance measurement TEG.
Fig. 11 is a diagram for explaining results of verifying the presence or absence of the occurrence of interface resistance at the bonded interface, wherein phosphorus ion implantation dependence of the characteristic ON resistance is verified.
Fig. 12 is a diagram for explaining results of verifying the presence or absence of the occurrence of interface resistance at the bonded interface, wherein the diagram shows results of current-voltage characteristics with phosphorus ion implantation (Example).
Fig. 13 is a diagram for explaining results of verifying the presence or absence of the occurrence of interface resistance at the bonded interface, wherein the diagram shows results of current-voltage characteristics without phosphorus ion implantation (Comparative Example).

### Description of Embodiments

In the present specification, a semiconductor substrate and a method for manufacturing a semiconductor substrate are disclosed. The semiconductor substrate is characterized in that a surface of a semiconductor layer and a surface of another semiconductor layer are bonded to each other to produce a semiconductor substrate having a bonded interface, and a specific element of the semiconductor layer is moved to a damaged layer by subsequent thermal treatment.

When semiconductor substrates are directly bonded to each other, a potential barrier is generated due to band offset or interface charges, so that interface resistance is increased. Therefore, a specific element of an n-type dopant is introduced in the vicinity of the junction, and electrons tunnel through the potential barrier, whereby the interface resistance can be suppressed.

Hereinafter, an example of an embodiment of the present invention will be described with reference to the drawings.

### [Semiconductor Substrate]

The semiconductor substrate includes a first semiconductor substrate and a second semiconductor substrate. The first semiconductor substrate and the second semiconductor substrate are bonded via a bonded interface.

### <Configuration of Semiconductor Substrate>

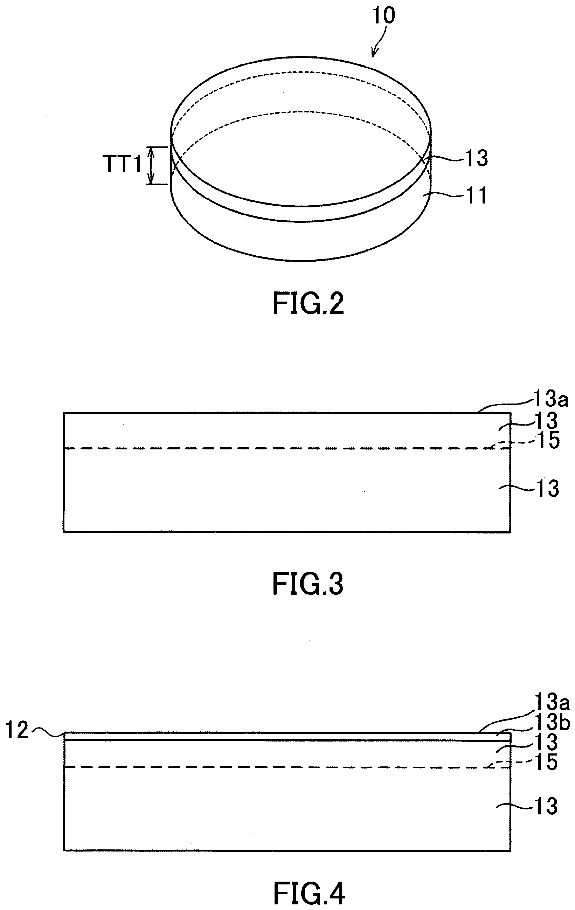

Fig. 2 is a perspective view illustrating an example of a semiconductor substrate of the present invention. A semiconductor substrate 10 of the present invention is a bonded semiconductor substrate, and is formed in, for example, a substantially disk shape having an orientation flat. The semiconductor substrate 10 includes a support substrate 11 which is an example of the first semiconductor substrate, and a single crystal substrate 13 which is an example of the second semiconductor substrate, and the single crystal substrate 13 is bonded to the support substrate 11.

The single crystal substrate 13 may be, for example, any of a compound semiconductor (e.g.: silicon carbide (SiC), gallium nitride (GaN), aluminum nitride (AlN), or gallium oxide (Ga₂O₃), a single element semiconductor (e.g.: silicon (Si) or carbon (C)), and diamond. These elements are semiconductor materials that can be used for semiconductor device fabrication.

For the support substrate 11, various materials can be used. It is preferable that the support substrate 11 is resistant to various thermal processes applied to the single crystal substrate 13. It is preferable that the support substrate 11 is formed from a material with a small difference in thermal expansion coefficient between the single crystal substrate 13 and the support substrate 11. For example, silicon carbide (SiC), silicon (Si), carbon (C), gallium nitride (GaN), aluminum nitride (AlN), gallium oxide (Ga₂O₃) , sapphire (Al₂O₃) , quartz (SiO₂), diamond, and the like can be used for the support substrate 11.

When polycrystal SiC is used for the support substrate 11, various poly-types and crystal face of SiC crystal may be mixed. Polycrystal SiC in which various poly-types and crystal face are mixed can be manufactured without severe temperature control, thus it can be enable a reduction in the manufacturing cost of the support substrate 11.

A thickness TT1 of the support substrate 11 may be determined so as to obtain mechanical strength capable of withstanding processing in a subsequent step. For example, when the diameter of the support substrate 11 is 150 (mm), the thickness TT1 may be about 350 (µm).

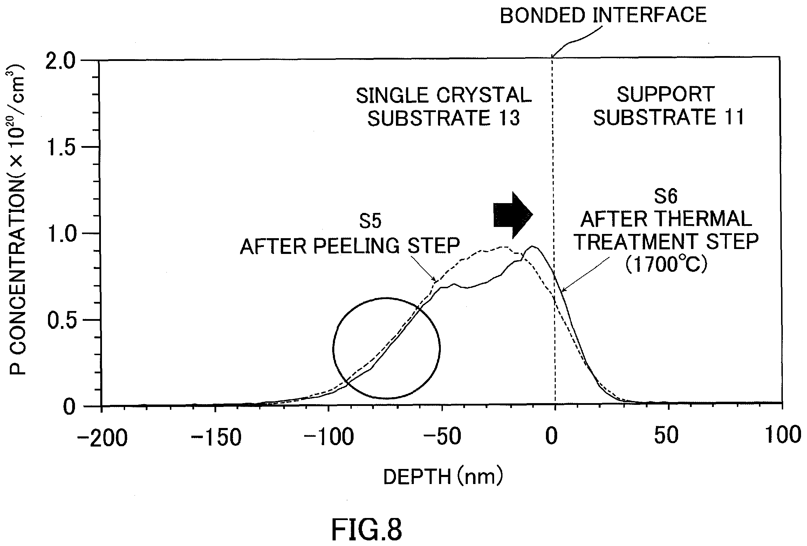

Fig. 8 is a graph showing phosphorus concentration profiles at a bonded interface and in the vicinity of the bonded interface after a peeling step and after a thermal treatment step. Although details of these steps will be described later, the X axis in Fig. 8 indicates 0 as a bonded interface between the support substrate 11 and the single crystal substrate 13 of the semiconductor substrate 10, the right side of the dotted line attached in the vertical direction is the support substrate 11, and the distance from 0 as the bonded interface is indicated as the depth of the support substrate 11 from the bonded interface. Polycrystal SiC is used as the support substrate 11, and 4H-SiC is used as the single crystal substrate 13. The left side of the dotted line is the single crystal substrate 13, and the distance from 0 as the bonded interface is indicated as the depth of the single crystal substrate 13 from the bonded interface as in the case of the support substrate 11. The Y axis represents the concentration of phosphorus, which is an example of the specific element. That is, Fig. 8 shows how much phosphorus is present at which depth from the bonded interface in the bonded semiconductor substrate.

The graph indicated by the solid line in Fig. 8 shows a phosphorus concentration in a semiconductor substrate of an example of the present invention. From this graph, it can be seen that the phosphorus concentration is the highest in a region 15 nm from the bonded interface, the phosphorus concentration at the bonded interface is 8×10¹⁹/cm³, and the phosphorus concentration is high in the region 15 nm from the bonded interface and a region 50 nm away from the bonded interface.

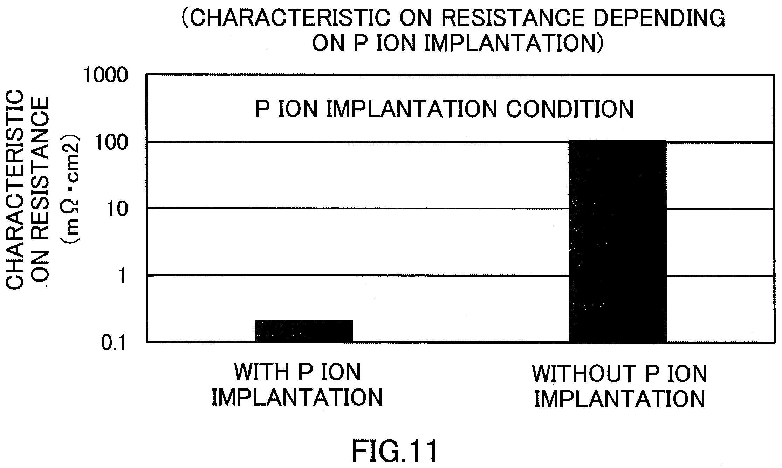

Figs. 11 to 13 are diagrams for explaining results of verifying the presence or absence of the occurrence of interface resistance at the bonded interface. Although details will be described later, Figs. 11 to 13 show results of measuring the characteristic ON resistance using the semiconductor substrate 10 used to show the result of the linear graph of Fig. 8, and the result of "with P ion implantation" corresponds to this. "Without P ion implantation" is the result of measuring the ON resistance using an existing semiconductor substrate in which a specific element introduction step described later is not performed. Comparing both results, it can be seen that the resistance at the bonded interface observed in "without P ion implantation" was not detected in "with P ion implantation", and the occurrence of interface resistance at the bonded interface could be prevented.

From the results of Figs. 8 and 11 to 13, in the semiconductor substrate 10 in which the phosphorus concentration is the highest in the region 15 nm from the bonded interface, the phosphorus concentration at the bonded interface is 8×10¹⁹/cm³, and the phosphorus concentration is high in the region 15 nm from the bonded interface and the region 50 nm away from the bonded interface, interface resistance at the bonded interface does not occur.

Note that, Figs. 8 and 11 to 13 are merely results in the case of using phosphorus as the specific element in the predetermined semiconductor substrate 10, and the semiconductor substrate of the present invention is not limited to these results.

That is, the semiconductor substrate of the present invention is a semiconductor substrate in which the concentration of the specific element is the highest in at least one of the bonded interface and a region from the bonded interface to a vicinity of 15 nm. Since the concentration of the specific element is the highest in the region close to the bonded interface as described above, the occurrence of interface resistance at the bonded interface can be prevented. When the concentration of the specific element is the highest in a region more than about 15 nm away from the bonded interface, there is a concern that the occurrence of interface resistance at the bonded interface cannot be prevented because the influence of the specific element on the bonded interface is small.

In the semiconductor substrate of the present invention, the concentration of the specific element at the bonded interface is preferably 1.0×10¹⁹ atoms/cm³ to 2.0×10²⁰ atoms/cm³. When such a concentration is less than 1.0×10¹⁹ atoms/cm³, there is a concern that the occurrence of interface resistance at the bonded interface cannot be prevented because the concentration of the specific element is low. When such a concentration is 2.0×10²⁰ atoms/cm³, the occurrence of interface resistance at the bonded interface can be sufficiently prevented.

In the semiconductor substrate of the present invention, the concentration of the specific element may be high in at least one of the bonded interface and a region from the bonded interface to a vicinity of 15 nm and in a region 40 nm to 60 nm away from the bonded interface.

More specifically, based on the results shown in Figs. 8 and 11 to 13, the semiconductor substrate of the present invention is a semiconductor substrate in which the first semiconductor substrate is a SiC polycrystal substrate, the second semiconductor substrate is a SiC single crystal substrate, a concentration of phosphorus at the bonded interface is 1.0×10¹⁹ atoms/cm³ to 2.0×10²⁰ atoms/cm³, and the resistance at the bonded interface is not detected.

Note that, the specific element is not limited to phosphorus, and examples thereof include a trivalent element and a pentavalent element which are used as dopants. Examples thereof include at least one of nitrogen (N), phosphorus (P), boron (B), and aluminum (Al).

The semiconductor substrate of the present invention may include a damaged layer described later in at least one of the bonded interface and a region from the bonded interface to a vicinity of 15 nm, and at least one of silicon (Si), carbon (C), helium (He), neon (Ne), argon (Ar), xenon (Xe), hydrogen (H), nitrogen (N), phosphorus (P), boron (B), and aluminum (Al) may be present in the damaged layer. Note that, the presence or absence of the damaged layer in the semiconductor substrate can be analyzed by a transmission electron microscope (TEM), and the damaged layer can be analyzed by confirming crystallinity (degree of amorphization and presence or absence of occurrence of crystal defects) with the TEM.

### [Method for Manufacturing Semiconductor Substrate]

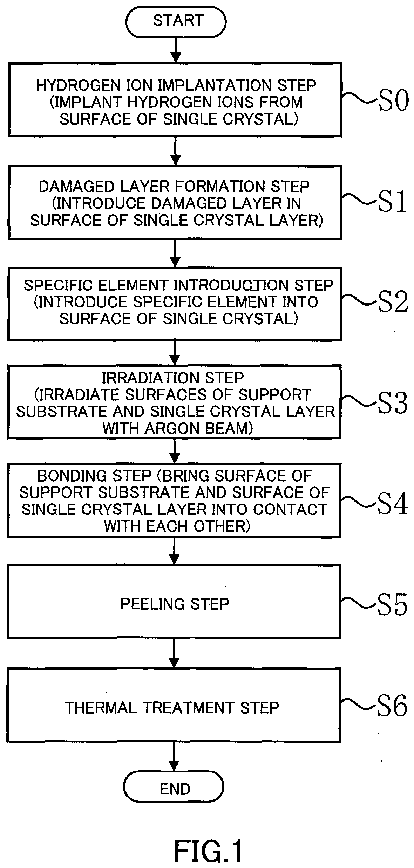

Next, as an example of a method for manufacturing a second semiconductor substrate including a first semiconductor substrate and a second semiconductor substrate of the present invention, a method for manufacturing the semiconductor substrate 10 in which the support substrate 11 as the first semiconductor substrate is polycrystal SiC and the single crystal substrate 13 as the second semiconductor substrate is single crystal 4H-SiC will be described. Here, a case where the semiconductor substrate 10 is manufactured using a peeling technique of the single crystal substrate 13 by ablation of hydrogen atoms will be described with reference to the flowchart illustrated in Fig. 1 and the like.

First, the support substrate 11 and the single crystal substrate 13 are prepared. As the support substrate 11 and the single crystal substrate 13, those in which a bonding target surface is already planarized can be obtained. The planarization may be performed by grinding or cutting, or may be performed by a CMP method.

### <Hydrogen Ion Implantation Step (Step S0)>

In step S0 of Fig. 1, a hydrogen ion implantation step of implanting hydrogen ions from a bonding target surface 13a of the single crystal substrate 13 is performed. When hydrogen ions are implanted into the single crystal substrate 13, the hydrogen ions reach a depth corresponding to incident energy and are distributed at a high concentration. As a result, as illustrated in the schematic side view of Fig. 3, a hydrogen-implanted layer 15 indicated by the dotted line is formed at a predetermined depth from the bonding target surface 13a. For example, the hydrogen-implanted layer 15 is formed at a position of about 0.6 µm in depth from the bonding target surface 13a.

Note that, the hydrogen ion implantation step is not an essential step in the present invention, but a substrate after hydrogen ion implantation may be obtained by, for example, purchasing and the present invention may be carried out using this substrate. This step is, for example, a step that can be adopted when the first semiconductor substrate is a SiC polycrystal substrate and the second semiconductor substrate is a SiC single crystal substrate or the first semiconductor substrate is a Si substrate and the second semiconductor substrate is a Si substrate. Note that, the hydrogen ion implantation step is a step that may be performed before a damaged layer formation step and before a specific element introduction step described later, or may be performed after the damaged layer formation step and after the specific element introduction step.

### <Damaged Layer Formation Step (Step S1)>

This step is a step of forming a damaged layer in at least one of a first bonding target surface of a first semiconductor substrate or a second bonding target surface of a second semiconductor substrate. That is, this step is a step of forming a damaged layer in a bonding target surface 11a or a bonding target surface 13a, and the damaged layer may be formed in both of the bonding target surface 11a and the bonding target surface 13a.

In Fig. 1, in Step S1, a damaged layer is formed in the bonding target surface 13a of the single crystal substrate 13. The damaged layer may be a layer in which the crystal structure is changed. Here, the aspect of the "layer in which the crystal structure is changed" includes various aspects. For example, a layer in which the crystal structure is changed due to generation of a large amount of crystal defects can be mentioned.

The aspect of the "layer in which the crystal structure is changed" includes an aspect in which the crystal structure itself is changed to a structure different from that before introduction of the specific element. An aspect in which the single crystal substrate 13 is amorphized is included. An aspect in which a compound other than SiC is included. An aspect in which some element is precipitated is included. Note that, these aspects are examples. It is not meant that aspects other than these aspects are excluded.

It is preferable to employ ion implantation using an ion implanter for formation of the damaged layer. By implanting ions inside the surface of the bonding target surface 13a by the ion implanter, the damaged layer can be effectively formed. In the ion implanter, the implantation depth and the like can be easily controlled by the acceleration voltage, the dose amount, and the like. Examples of the element of ions to be implanted include silicon (Si), carbon (C), helium (He), neon (Ne), argon (Ar), xenon (Xe), hydrogen (H), nitrogen (N), phosphorus (P), boron (B), and aluminum (Al).

As an example of an embodiment of the present invention, when argon (Ar) is used as an element of ions used for forming the damaged layer, specifically, the single crystal substrate 13 is installed in an ion implanter, and argon (Ar) is implanted into the surface 13a of the single crystal substrate 13 by ion implantation. As conditions for ion implantation, for example, a dose amount is 10¹⁴ to 10¹⁶ atoms/cm², and an acceleration voltage is 0.1 to 70 kV. In the ion implantation, the ion concentration may be controlled to be maximum on the surface of the single crystal substrate 13. After the ion implantation, as illustrated in the schematic view of Fig. 4, a damaged layer 12 is formed on the surface layer of the single crystal substrate 13. Note that, when Ar is implanted by ion implantation, crystallinity collapses and changes to amorphous, and this change can be confirmed by a transmission electron microscope (TEM).

By forming such a damaged layer, as described later, the specific element easily moves in the substrate in the thermal treatment step.

### <Specific Element Introduction Step (Step S2)>

This step is a step of introducing a specific element into at least one of the first bonding target surface and the second bonding target surface. That is, this step is a step of introducing a specific element into the bonding target surface 11a or the bonding target surface 13a, and the specific element may be into both of the bonding target surface 11a and the bonding target surface 13a.

In Fig. 1, in Step S2, a specific element introduction step is performed. The specific element is preferably an element that can be bonded to Si or C when the substrate is SiC. In the present example, the case of using phosphorus (P) as the specific element will be described below. Phosphorus (P) is introduced into a deep region including the damaged layer 12 from the surface 13a of the single crystal substrate 13 by ion implantation. As a result, as illustrated in the schematic view of Fig. 4, a doping layer 13b is formed on the surface layer of the single crystal substrate 13.

Note that, when the first semiconductor substrate and the second semiconductor substrate are N-type semiconductors, a pentavalent element is used as the specific element, and when the first semiconductor substrate and the second semiconductor substrate are P-type semiconductors, a trivalent element is used as the specific element.

### <Irradiation Step (Step S3)>

This step is a step of irradiating at least one of the first bonding target surface and the second bonding target surface with an argon beam after the damaged layer formation step and after the specific element introduction step and before the bonding step. That is, this step is a step of irradiating the bonding target surface 11a or the bonding target surface 13a with an argon beam, and both of the bonding target surface 11a and the bonding target surface 13a may be irradiated with an argon beam.

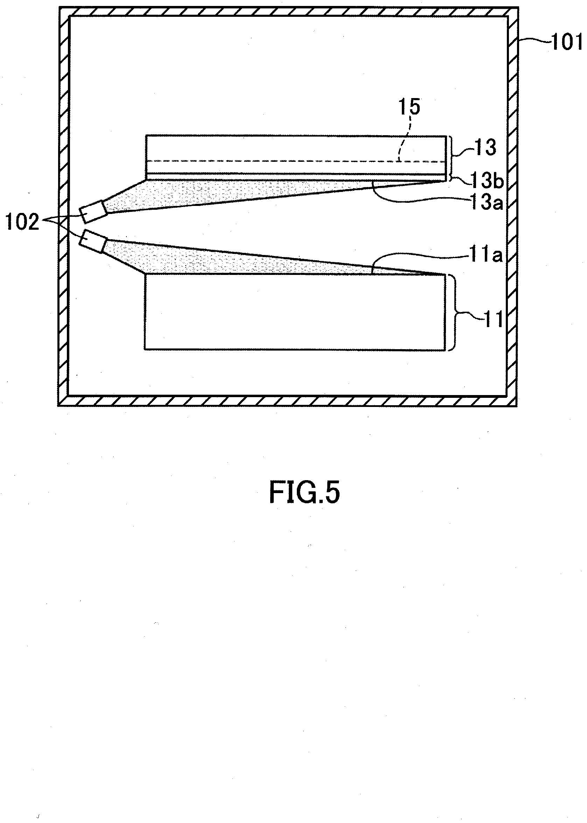

In Step S3 of Fig. 1, an irradiation step is performed. As illustrated in Fig. 5, the single crystal substrate 13 and the support substrate 11 are set in a chamber 101. Next, the relative positions of the single crystal substrate 13 and the support substrate 11 are aligned. The alignment is performed such that both substrates can be brought into contact with each other in a correct positional relationship in a bonding step described later. Next, the inside of the chamber 101 is brought into a vacuum state. The degree of vacuum in the chamber 101 may be, for example, about 1×10-⁴ to 1×10-⁶ Pa.

Next, the bonding target surface 11a of the support substrate 11 and the bonding target surface 13a of the single crystal substrate 13 are irradiated with beams of neutral elements of argon (Ar) using fast atomic beam guns (FAB guns) 102. The entire surface of the bonding target surface 11a and the entire surface of the bonding target surface 13a are uniformly irradiated with the beams of neutral elements of argon (Ar). As a result, an oxide film or an adsorption layer on the bonding target surface 11a and the bonding target surface 13a can be removed to expose dangling bonds. A state in which the oxide film or the adsorption layer is removed to expose dangling bonds is referred to as an active state. Since the irradiation step is a process in vacuum, the bonding target surface 11a and the bonding target surface 13a can maintain an active state without being oxidized or the like.

Note that, the irradiation step is not an essential step, and can be omitted as long as a bonded semiconductor substrate can be formed without any problem by bonding two substrates by a bonding step described later. The irradiation step is a step of removing an oxide or an adsorption layer on the surface by a sputtering phenomenon by causing atoms or molecules to collide with the surface, but instead of this step, a step of chemically reacting an oxide or an adsorption layer with contaminants on the surface with a reactive gas and removing the oxide or the adsorption layer by etching is conceivable, and an adsorbent can be removed by sublimation by simply applying heat or light as long as it is an adsorbent which is easily sublimated. By these steps instead of the irradiation step, the oxide film or the adsorption layer on the bonding target surface can be removed to expose dangling bonds.

### <Bonding Step (Step S4)>

This step is a step of forming bonding the first bonding target surface and the second bonding target surface together to form a bonded semiconductor substrate having a bonded interface after the damaged layer formation step and after the specific element introduction step.

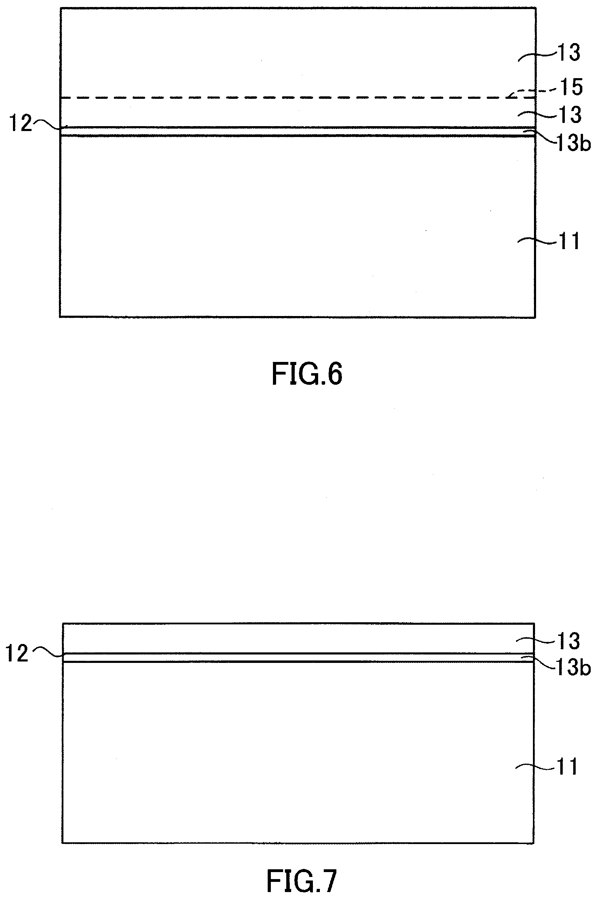

In Step S4 of Fig. 1, a bonding step is performed. In the bonding step, the bonding target surface 11a of the support substrate 11 and the bonding target surface 13a of the single crystal substrate 13 are brought into contact with each other in vacuum in the chamber 101. Dangling bonds existing on the bonding target surface 11a and the bonding target surface 13a in an active state are bonded to each other, and the support substrate 11 and the single crystal substrate 13 can be bonded. As a result, as illustrated in the schematic view of Fig. 6, a structure in which the support substrate 11 and the single crystal substrate 13 are bonded is formed.

### <Peeling Step (Step S5)>

This step is a step of forming a microbubble layer in the hydrogen-implanted layer 15 by applying heat during the peeling step after the bonding step and before the thermal treatment step, and peeling the second semiconductor substrate using the microbubble layer as a peeling surface. That is, the single crystal substrate 13 is peeled using, as a peeling surface, the hydrogen-implanted layer 15 in which the microbubble layer as the single crystal substrate 13 is formed.

In Step S5 of Fig. 1, a peeling step is performed. Specifically, the support substrate 11 and the single crystal substrate 13 bonded to each other are heated to about 800°C or higher. The atmosphere for peeling may be at least one atmosphere of an inert gas such as argon (Ar) or nitrogen (N) and vacuum. Peeling may be performed using rapid thermal annealing (RTA) or a furnace. As a result, the single crystal substrate 13 can be separated by the hydrogen-implanted layer 15. Therefore, as illustrated in the schematic view of Fig. 7, a structure in which the single crystal substrate 13 having a thin thickness of, for example, 0.6 µm is bonded on the support substrate 11 via the doping layer 13b.

### <Thermal Treatment Step (Step S6)>

This step is a step of subjecting the bonded semiconductor substrate to a thermal treatment, and is a step of causing the specific element introduced into the first semiconductor substrate or the second semiconductor substrate to move into the damaged layer of the first semiconductor substrate or the damaged layer of the second semiconductor substrate.

In Step S6 of Fig. 1, a thermal treatment step is performed. In the thermal treatment step, the support substrate 11, the doping layer 13b, and the single crystal substrate 13 are subjected to a thermal treatment. The thermal treatment temperature may be preferably a temperature at which the introduced phosphorus is activated, and heating may be performed at 1100°C to 2200°C (preferably about 1700°C). The atmosphere for the thermal treatment may be at least one atmosphere of an inert gas such as argon (Ar) or nitrogen (N) and vacuum. The thermal treatment step may be performed in the furnace in which the peeling step has been performed. As a result, phosphorus present in the doping layer 13b moves to the damaged layer 12 in the vicinity of the bonded interface between the support substrate 11 and the single crystal substrate 13.

### <Movement of Phosphorus to Damaged Layer>

The movement of phosphorus existing in the doping layer 13b to the damaged layer 12 in the vicinity of the bonded interface in the thermal treatment step of Step S6 will be described with reference to Fig. 8. Measurement substrates are the single crystal substrate 13 of 4H-SiC and the support substrate 11 of polycrystal SiC which are bonded by a bonding method described in the present specification. A phosphorus concentration profile after the peeling step of Step S5 and before the thermal treatment step of Step S6 and a phosphorus concentration profile after the thermal treatment step of Step S6 were measured by SIMS analysis. In Fig. 8, the vertical axis represents the phosphorus concentration (atoms/cm³). The horizontal axis indicates the depth (nm) in the vicinity of the interface between the single crystal substrate 13 and the support substrate 11, and the depth of 0 nm indicates the bonded interface between the support substrate 11 and the single crystal substrate 13.

When peak positions of the phosphorus concentrations after the peeling step of Step S5 and after the thermal treatment step of Step S6 are compared with each other, it can be clearly seen that phosphorus moves to the vicinity of the bonded interface by the thermal treatment at 1700°C in Step S6, and as a result, one concentration peak before the thermal treatment step becomes two concentration peaks in the damaged layer 12 and the doping layer 13b in the vicinity of the bonded interface.

A circle in Fig. 8 indicates a phosphorus concentration distribution in the single crystal substrate 13 instead of the damaged layer 12. According to this concentration distribution, since a change in phosphorus concentration distribution before and after the thermal treatment step is not observed, it can be seen that diffusion of phosphorus in a direction away from the bonded interface in the single crystal substrate 13 does not occur even in the thermal treatment at 1700°C, and phosphorus does not move to the vicinity of the bonded interface due to a simple thermal diffusion phenomenon caused by heating of the substrate. That is, it is considered that phosphorus moves to the damaged layer 12 in the vicinity of the bonded interface by the thermal treatment step and is gettered.

When the formation of the damaged layer, the introduction of the specific element, and the thermal treatment step are not performed, an energy barrier is formed at the bonded interface between the single crystal substrate 13 and the support substrate 11. However, by performing the formation of the damaged layer, the introduction of the specific element, and the thermal treatment step, phosphorus of an N-type dopant moves to the vicinity of the bonded interface, so that the width of the energy barrier can be reduced. As a result, a tunnel effect can be obtained, so that interface resistance at the bonded interface can be reduced.

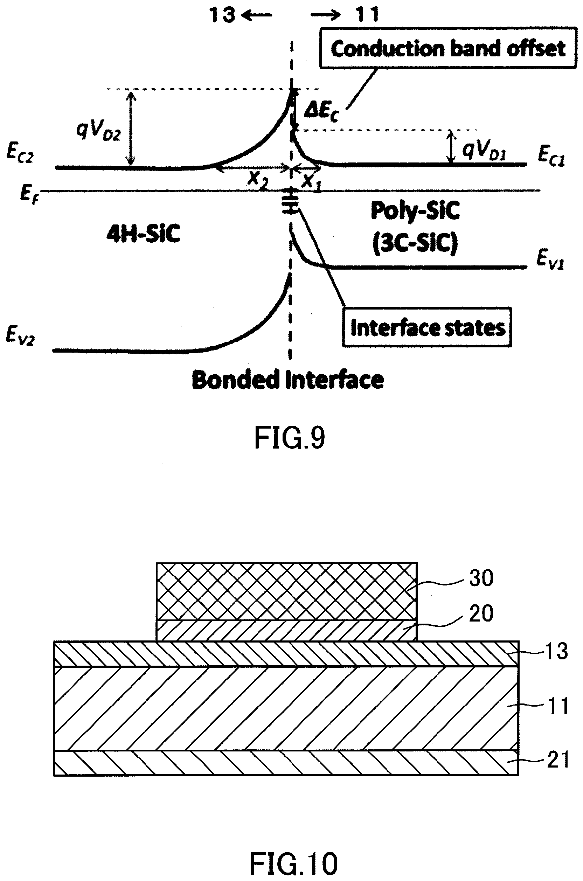

Effects obtained by the technique disclosed in the present specification will be described from another aspect. An example of a cause of the occurrence of non-ohmic electrical characteristics at the bonded interface between the support substrate 11 and the single crystal substrate 13 is a difference in bandgap energy between the semiconductor substrates of the support substrate 11 and the single crystal substrate 13. As illustrated in Fig. 9, quantum-mechanically, a potential barrier is considered to be present. In the case example in Fig. 9, a case where the support substrate 11 is made of n-type 3C-SiC polycrystal and has a bandgap energy of 2.2 V is illustrated. A case where the single crystal substrate 13 is made of 4H-SiC single crystal and has a bandgap energy of 3.2 V is illustrated. Such a potential barrier is considered to be generated at the bonded interface and a region in the vicinity thereof due to the difference in bandgap energy between 4H and 3C, trap level generated by irradiation with argon present at the bonded interface, the unconformity of the bonded interface, and the like. According to the present invention, phosphorus as an n-type high-concentration carrier can be moved to the vicinity of the bonded interface. This makes it possible to bring about improvement in non-ohmic characteristics by inducing tunneling.

From the results of Figs. 8 and 9, it is obvious that the width of the energy barrier at the bonded interface between the single crystal substrate 13 and the support substrate 11 can be further reduced by performing the formation of the damaged layer and the introduction of the specific element with respect to not only the single crystal substrate 13 but also the support substrate 11.

That is, the damaged layer formation step in the present invention is preferably a step of forming a damaged layer in the first bonding target surface and the second bonding target surface. The specific element introduction step in the present invention is preferably a step of introducing a specific element into the first bonding target surface and the second bonding target surface.

### <Effects>

In the present invention, a surface of a semiconductor layer and a surface of another semiconductor layer are bonded to each other to produce a semiconductor substrate having a bonded interface, and a specific element of the semiconductor layer is moved to a damaged layer by subsequent thermal treatment. As a result, electrons tunnel through the potential barrier of the bonded interface, whereby the interface resistance can be reduced.

When an element, which is difficult to handle, such as phosphorus is used as the element to be introduced into the bonding target surface 13a, the manufacturing cost may increase. This is because it is necessary to perform detoxification of a gas generated from a manufacturing apparatus and to increase the periodic cleaning frequency of the manufacturing apparatus. Therefore, in the present invention, nitrogen can be used instead of phosphorus as an element to be excessively introduced. Since nitrogen is easier to handle than phosphorus or the like, it is possible to suppress the manufacturing cost.

### <Modification>

Although one embodiment of the present invention has been described in detail above, these are merely examples, and do not limit the scope of the present invention. For example, as described below, the present invention includes various modifications and changes of the specific examples exemplified above.

The element used for forming the damaged layer may be silicon (Si). In this case, in the composition ratio of the elements at the bonded interface, the proportion of silicon is larger than that of carbon. In this case, it can be said that the interface is made of silicon-rich SiC. For example, the composition ratio of silicon is in a range of 50 to 60 atomic%. Since silicon is present at a very high concentration at the interface, the crystal structure of SiC cannot be maintained, and the crystal structure is changed from SiC. That is, the interface is made of a composite material including carbon and silicon. At the interface, a damaged layer having very many crystal defects can be formed.

The element used for forming the damaged layer may be carbon (C). In this case, in the composition ratio of the elements at the interface, the proportion of carbon is larger than that of silicon. In this case, it can be said that the interface is made of carbon-rich SiC. For example, the composition ratio of carbon is in a range of 50 to 60 atomic%. Also in this case, as described above, the crystal structure is changed from SiC. That is, at the interface, a damaged layer of a composite material including carbon and silicon can be formed.

The element used for the damaged layer is an element that hardly becomes a carrier and may be an element having a high effect of forming damage. For example, the element may be at least one of rare gases such as helium (He), neon (Ne), argon (Ar), and xenon (Xe) and hydrogen (H).

The element used for the damaged layer is an element that easily becomes a carrier and may be an element having a high effect of forming damage. The element may be, for example, at least one of nitrogen (N), phosphorus (P), boron (B), and aluminum (Al).

In the damaged layer formation step described in Step S1, various forming methods can be used. For example, plasma irradiation for ionizing a specific element gas to be irradiated and irradiating the substrate may be used. Neutral element implantation may also be used.

The specific element may be at least one of nitrogen (N), phosphorus (P), boron (B), and aluminum (Al). These elements are highly effective elements that become n-type or p-type dopants in SiC to generate carriers of electrons or holes.

In the irradiation step (Step S3), ions of a specific element that generates carriers may be applied. In the present invention, in the irradiation step, ions of nitrogen, phosphorus, or the like may be also applied.

In the irradiation step, it is preferable to perform irradiation with nitrogen. As a result, a treatment of activating the bonding target surfaces of the support substrate 11 and the single crystal substrate 13 can also function as a treatment of introducing nitrogen, phosphorus, or the like into the support substrate 11 and the single crystal substrate 13. Therefore, since the specific element introduction step (Step S2) can be omitted, the number of steps can be reduced. A device used for activating the bonding target surface is not limited to the FAB gun, and various devices such as an ion gun can be used.

In the damaged layer formation step and the specific element introduction step, ions may be implanted via a mask material. The mask material may be at least one of a silicon oxide film, a silicon nitride film, and a resist.

In the damaged layer formation step described in Step S1 and the specific element introduction step described in Step S2, the case of forming a damaged layer and introducing a specific element only to the single crystal substrate 13 has been described, but the present invention is not limited to this aspect. The damaged layer formation and the specific element introduction may be performed with respect to both of the single crystal substrate 13 and the support substrate 11, and the damaged layer formation and the specific element introduction may be performed only with respect to the support substrate 11. For example, when the support substrate 11 is polycrystal SiC subjected to a resistance-reducing process, the implantation of a specific element that is to serve as an n-type carrier into the bonding target surface of the support substrate 11 can be omitted. An example of polycrystal SiC subjected to a resistance-reducing process is polycrystal SiC in which a specific element has been introduced in advance.

The front-to-back order of the damaged layer formation step and the specific element introduction step may be switched. For example, the damaged layer 12 can also be formed in the bonding target surface of the single crystal substrate 13 by introducing phosphorus as a specific element into the single crystal substrate 13 and then ion-implanting argon into the single crystal substrate 13.

That is, in the present invention, the specific element introduction step may be performed after the damaged layer formation step, or the damaged layer formation step may be performed after the specific element introduction step.

The specific element introduction step may be performed after the peeling step (Step S5). For example, phosphorus ions as a specific element may be implanted into the inside from the single crystal layer surface 13 by ion implantation. At that time, various parameters such as accelerating energy and an angle of incidence may be set so that phosphorus is maximized in the vicinity of the bonded interface. For example, by performing multi-stage implantation in which implantation is performed more than once with varied accelerating energies, control may be exercised so that the highest phosphorus concentration is achieved in the vicinity of the bonded interface.

The specific element that generates carriers in the support substrate 11 and the single crystal substrate 13 is not limited to an embodiment in which it is introduced in the specific element introduction step. The specific element introduction step may be omitted by using the support substrate 11 and the single crystal substrate 13 in which a specific element has been introduced in advance. In the present embodiment, it is only necessary to use an n-type support substrate 11 and an n-type single crystal substrate 13 that are doped with a high concentration of nitrogen, phosphorus, or the like. The concentration of a specific element with which the substrate is doped in advance needs only be equal to or higher than the concentration of a specific element at the bonded interface that is introduced in the specific element introduction step. In the present embodiment, it is only necessary to use an n-type support substrate 11 and an n-type single crystal substrate 13 that are doped with 1×10¹⁹/cm³ or more of nitrogen or phosphorus.

Note that, in the present invention, the specific element introduction step may not be omitted, and for example, a specific element introduction step of introducing a specific element into the first bonding target surface of the first semiconductor substrate into which a specific element is not introduced or the second bonding target surface of the second semiconductor substrate into which a specific element is not introduced may be included before the damaged layer formation step.

The method used in the specific element introduction step (Step S2) can be ion implantation, neutral element implantation, or plasma doping, but a thermal diffusion method other than these methods can be used. The thermal diffusion method is based on the principle that the support substrate 11 and the single crystal substrate 13 are heated with a high concentration of a specific element such as phosphorus present therearound. Therefore, the concentration of a specific element such as phosphorus can be maximized on the surfaces of the support substrate 11 and the single crystal substrate 13. The width of the concentration profile of the specific element can be narrowed as compared with the case of using an ion implantation method. This makes it possible to form a concentration profile of the specific element having a width corresponding to the width (of about several nanometers) of a potential barrier that can be passed through by tunneling. Note that, when a semiconductor material into which a specific element is introduced is SiC, since SiC has a very small coefficient of thermal diffusivity of an impurity, it is preferable to perform a thermal treatment step of performing thermal diffusion at a high temperature of about 1100°C or higher. As a result, it is possible to perform diffusion of about several nanometers which can exhibit the tunnel effect.

In the present invention, the peeling step (Step S5) and the thermal treatment step (Step S6) can also be integrated. Specifically, in the peeling step, heating may be performed at a temperature higher than the temperature at which the specific element moves to the damaged layer. This makes it possible to the number of steps.

In the present invention, after the thermal treatment step (Step S6), a single crystal layer having a necessary thickness may be epitaxially grown on the single crystal substrate 13. The epitaxial layer serves as a formation region of various elements. The thickness of the epitaxial layer required for forming various elements is approximately 5 µm or more in the case of SiC.

When SiC is used for the single crystal substrate 13, SiC is not limited to 4H-SiC single crystal. Various polytypes of single crystal SiC such as 3C-SiC and 6H-SiC can be used as the single crystal substrate 13. When polycrystal SiC is used for the support substrate 11, polycrystal SiC is not limited to 3C-SiC polycrystal. Various polytypes of polycrystal SiC can be used.

### Examples

Hereinafter, the present invention will be described more specifically with reference to Examples, but the present invention is not limited to the following Examples at all.

In the present example, a SiC single crystal substrate was used as the single crystal substrate 13, a SiC polycrystal substrate was used as the support substrate 11, and these substrates were bonded to manufacture the semiconductor substrate 10. The phosphorus concentration shown in Fig. 8 and the interface resistance shown in Fig. 11 were measured using the manufactured semiconductor substrate 10.

### [Example 1]

### <Manufacture of Semiconductor Substrate 10>

As the single crystal substrate 13, a 4H-SiC single crystal substrate manufactured by a sublimation method and having a diameter dimension of 6 inches was used. As the support substrate 11, a 3C-SiC polycrystal substrate having a diameter of 6 inches obtained by forming a SiC polycrystal film by a chemical vapor deposition method was used. First, before the damaged layer formation step, the bonding target surfaces 11a and 13a of the single crystal substrate 13 and the support substrate 11 were subjected to mirror polishing processing and cleaning.

### (Hydrogen Ion Implantation Step S0)

Hydrogen ions were implanted into the bonding target surface 13a of the single crystal substrate 13 at a position of about 0.6 µm in depth from the bonding target surface 13a to form the hydrogen-implanted layer 15. The hydrogen-implanted layer 15 is amorphized at the time of hydrogen ion implantation, and microbubbles are formed by heat applied in the subsequent peeling step S5 to peel off the single crystal substrate.

### (Damaged Layer Formation Step S1)

In the present example, as the damaged layer formation step S1, the surface 13a of the single crystal substrate 13 was irradiated with argon using an ion implanter. The implantation conditions are, for example, a dose amount of 10¹⁴ to 10¹⁶ atoms/cm² and an acceleration voltage of 0.1 to 70 kV.

### (Specific Element Introduction Step S2)

Phosphorus ions were implanted from the surface 13a of the single crystal substrate 13 using an ion implanter to form the doping layer 13b. The phosphorus concentration of the surface 13a at that time was 8×10¹⁹/cm³.

### (Irradiation Step S3)

First, the bonding target surfaces 11a and 13a were subjected to mirror polishing processing and cleaning. Next, the bonding target surface 11a and the bonding target surface 13a were irradiated with an argon beam.

Specifically, as illustrated in Fig. 5, the single crystal substrate 13 and the support substrate 11 were set in the chamber 101, and the relative positions of the single crystal substrate 13 and the support substrate 11 were aligned. Next, the inside of the chamber 101 was brought into a vacuum state so that the degree of vacuum was 1×10⁻⁴ to 1×10⁻⁶ Pa.

Next, the bonding target surface 11a of the support substrate 11 and the bonding target surface 13a of the single crystal substrate 13 were irradiated with beams of neutral elements of argon using the FAB guns 102. The entire surface of the bonding target surface 11a and the entire surface of the bonding target surface 13a were uniformly irradiated with the beams of neutral elements of argon.

### (Bonding Step S4)

After the irradiation step, the activated bonding target surface 11a of the support substrate 11 and the activated bonding target surface 13a of the single crystal substrate 13 were brought into contact with each other while maintaining a vacuum state in the chamber 101, and further pressurized to obtain a bonded substrate of the support substrate 11 and the single crystal substrate 13.

### (Peeling Step S5)

The bonded substrate was heated in an inert atmosphere filled with nitrogen gas using a furnace, and the single crystal substrate 13 was separated by the hydrogen-implanted layer 15 to form a bonded substrate to which the thin single crystal substrate 13 having a thickness of 0.6 µm was bonded.

### (Thermal Treatment Step S6)

After the peeling step, the bonded substrate was heated at 1700°C in an inert atmosphere filled with argon gas in a furnace to obtain the semiconductor substrate 10.

### <Evaluation of Semiconductor Substrate 10>

### (Measurement of Phosphorus Concentration)

The phosphorus concentration of the manufactured semiconductor substrate 10 after the thermal treatment step was measured by secondary ion mass spectrometry (SIMS). As a comparison, the phosphorus concentration was also measured for the bonded substrate before the thermal treatment step and after the peeling step in the same manner. The results are shown in Fig. 8.

The X axis in Fig. 8 indicates 0 as a bonded interface between the support substrate 11 and the single crystal substrate 13 of the semiconductor substrate 10, the right side of the dotted line attached in the vertical direction is the support substrate 11, and the distance from 0 as the bonded interface is indicated as the depth. The left side of the dotted line is the single crystal substrate 13, and similarly, the distance from 0 as the bonded interface is indicated as the depth. The Y axis represents the concentration of phosphorus, which is an example of the specific element. That is, Fig. 8 shows how much phosphorus is present at which depth from the bonded interface in the bonded semiconductor substrate.

The graph indicated by the solid line in Fig. 8 shows the phosphorus concentration in the semiconductor substrate 10, and the graph indicated by the dotted line indicates the phosphorus concentration of the bonded substrate after the peeling step. From the graph indicated by the solid line, it can be seen that in the semiconductor substrate 10, the phosphorus concentration is the highest in the region 15 nm from the bonded interface, the phosphorus concentration at the bonded interface is 8×10¹⁹/cm³, and the phosphorus concentration is high in the region 15 nm from the bonded interface and the region 50 nm away from the bonded interface.

In the graph indicated by the dotted line, since the phosphorus concentration is the highest in the region of about 30 nm from the bonded interface, it can be seen that phosphorus moved to the bonded interface by the thermal treatment step. A region surrounded by a circle in Fig. 8 is a region in which the damaged layer is not formed, and since the phosphorus concentration hardly changes between the dotted line graph and the solid line graph, it can be seen that the phosphorus in the damaged layer easily moves to the bonded interface by forming the damaged layer.

### (Measurement of Interface Resistance)

Fig. 10 is a cross-sectional view of a characteristic ON resistance measurement TEG manufactured by way of trial this time. As a surface electrode in this cross-sectional view, an Al film 30 was deposited on a Ti film 20, and then an electrode was formed by patterning. The transfer layer under the Ti film 20 as a surface electrode is the single crystal substrate 13, the polycrystal support substrate under the single crystal substrate 13 is the support substrate 11, and a back surface electrode under the support substrate is a Ti film 21.

The characteristic ON resistance of the prepared TEG was measured using a semiconductor parameter analyzer (manufactured by Agilent Technologies). As a comparison, using a semiconductor substrate manufactured in the same manner as in Example except that phosphorus ions were not implanted without performing the specific element introduction step, the characteristic ON resistance of a TEG manufactured in the same manner was also measured in the same manner. The results thereof are shown in Fig. 11.

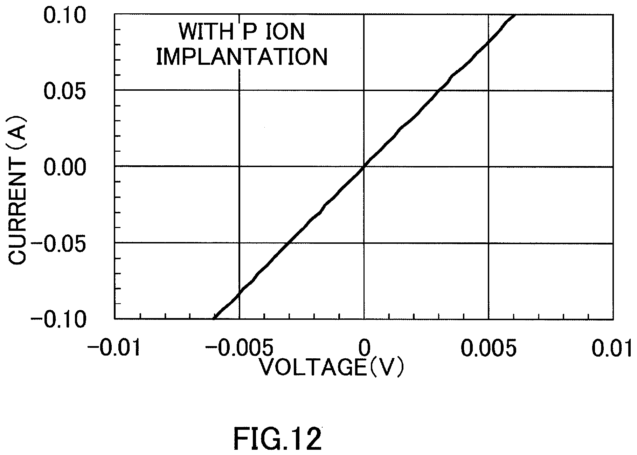

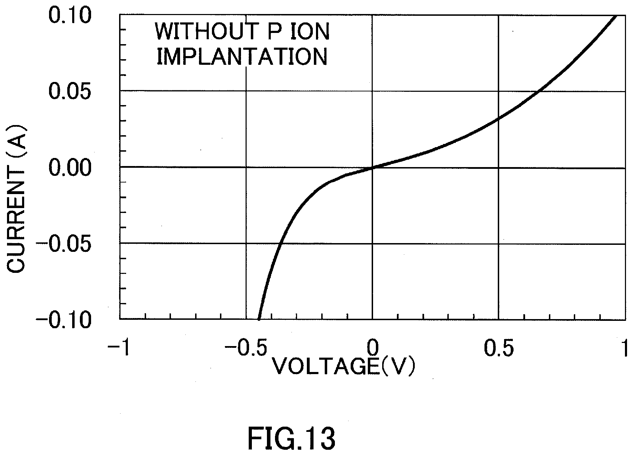

Fig. 11 shows the phosphorus ion implantation dependence of the characteristic ON resistance, Fig. 12 shows results of current-voltage characteristics with phosphorus ion implantation (Example), and Fig. 13 shows results of current-voltage characteristics without phosphorus ion implantation (Comparative Example). In Comparative Example without phosphorus ion implantation, the current-voltage characteristics are not linear but asymmetric, and the voltage thereof is also two orders of magnitude higher than that in Example with phosphorus ion implantation. This indicates the resistance at the bonded interface observed in "without phosphorus ion implantation". In the case of "with phosphorus ion implantation", linear ohmic characteristics are obtained. The resistance observed in "with phosphorus ion implantation" is the resistance of the bonded substrate itself, and interface resistance is a negligibly small value. That is, by the implantation of phosphorus ions, the characteristic ON resistance was reduced to a negligible level with respect to the substrate resistance. That is, since the interface resistance was much smaller than the substrate resistance, only the substrate resistance could be measured. That is, it can be seen that the resistance at the bonded interface observed in "without phosphorus ion implantation" was not detected in "with phosphorus ion implantation", and the occurrence of interface resistance at the bonded interface could be prevented.

From the results of Figs. 8 and 11 to 13, it can be seen that in the semiconductor substrate 10 in which the phosphorus concentration is the highest in the region 15 nm from the bonded interface, the phosphorus concentration at the bonded interface is 8×10¹⁹/cm³, and the phosphorus concentration is high in the region 15 nm from the bonded interface and the region 50 nm away from the bonded interface, interface resistance at the bonded interface does not occur.

### (Summary)

As described above, according to the present invention, it is possible to provide a semiconductor substrate capable of preventing occurrence of interface resistance at a bonded interface, and a method for manufacturing a semiconductor substrate, which is industrially useful.

### Reference Signs List

- 10: semiconductor substrate
- 11: support substrate
- 11a: bonding target surface
- 12: damaged layer
- 13: single crystal substrate
- 13a: bonding target surface
- 13b: doping layer
- 15: hydrogen-implanted layer
- 20: Ti film
- 21: Ti film
- 30: Al film
- 101: chamber
- 102: FAB gun

## Claims

1. A method for manufacturing a semiconductor substrate including a first semiconductor substrate and a second semiconductor substrate, the method comprising:
a damaged layer formation step of forming a damaged layer in at least one of a first bonding target surface of the first semiconductor substrate and a second bonding target surface of the second semiconductor substrate;
a specific element introduction step of introducing a specific element into at least one of the first bonding target surface and the second bonding target surface;
a bonding step of bonding the first bonding target surface and the second bonding target surface together to form a bonded semiconductor substrate having a bonded interface after the damaged layer formation step and after the specific element introduction step; and
a thermal treatment step for subjecting the bonded semiconductor substrate to a thermal treatment, wherein
the thermal treatment step is a step of causing the specific element introduced into at least one of the first semiconductor substrate and the second semiconductor substrate to move into the damaged layer of the first semiconductor substrate or the damaged layer of the second semiconductor substrate,
a pentavalent element is used as the specific element when the first semiconductor substrate and the second semiconductor substrate are N-type semiconductors, and
a trivalent element is used as the specific element when the first semiconductor substrate and the second semiconductor substrate are P-type semiconductors.

2. The method for manufacturing a semiconductor substrate according to claim 1, wherein the first semiconductor substrate and the second semiconductor substrate are any one of silicon carbide (SiC), silicon (Si), carbon (C), gallium nitride (GaN), aluminum nitride (AlN), gallium oxide (Ga₂O₃), and diamond.

3. The method for manufacturing a semiconductor substrate according to claim 1 or 2, wherein the specific element introduction step is performed after the damaged layer formation step, or the damaged layer formation step is performed after the specific element introduction step.

4. The method for manufacturing a semiconductor substrate according to claim 1, wherein at least one of silicon (Si), carbon (C), helium (He), neon (Ne), argon (Ar), xenon (Xe), hydrogen (H), nitrogen (N), phosphorus (P), boron (B), and aluminum (Al) is present in the damaged layer.

5. The method for manufacturing a semiconductor substrate according to claim 1, wherein the damaged layer formation step is a step of forming the damaged layer by performing at least one treatment of ion implantation, neutral element implantation, and plasma irradiation with respect to at least one of the first bonding target surface and the second bonding target surface.

6. The method for manufacturing a semiconductor substrate according to claim 1, wherein the specific element introduction step is a step of introducing the specific element by performing at least one treatment of ion implantation, neutral element implantation, plasma doping, and thermal diffusion with respect to at least one of the first bonding target surface and the second bonding target surface.

7. The method for manufacturing a semiconductor substrate according to claim 1, wherein the specific element is at least one of nitrogen (N), phosphorus (P), boron (B), and aluminum (Al).

8. The method for manufacturing a semiconductor substrate according to claim 1, wherein a thermal treatment temperature in the thermal treatment step is 1100°C to 2200°C.

9. The method for manufacturing a semiconductor substrate according to claim 1, comprising an irradiation step of irradiating at least one of the first bonding target surface and the second bonding target surface with an argon beam after the damaged layer formation step and after the specific element introduction step and before the bonding step.

10. The method for manufacturing a semiconductor substrate according to claim 1, wherein the first semiconductor substrate is a SiC polycrystal substrate and the second semiconductor substrate is a SiC single crystal substrate, the first semiconductor substrate is a Si substrate and the second semiconductor substrate is a Si substrate, the first semiconductor substrate is a gallium nitride (GaN) substrate and the second semiconductor substrate is a gallium nitride (GaN) substrate, the first semiconductor substrate is a gallium oxide (Ga₂O₃) substrate and the second semiconductor substrate is a gallium oxide (Ga₂O₃) substrate, or the first semiconductor substrate is a diamond substrate and the second semiconductor substrate is a diamond substrate, and
the method comprises a hydrogen ion implantation step of implanting hydrogen ions into the second bonding target surface before the damaged layer formation step and before the specific element introduction step.

11. The method for manufacturing a semiconductor substrate according to claim 10, comprising a peeling step of peeling the second semiconductor substrate using a microbubble layer as a peeling surface after the bonding step and before the thermal treatment step.

12. A semiconductor substrate comprising: a first semiconductor substrate; and a second semiconductor substrate bonded to the first semiconductor substrate via a bonded interface, wherein
a concentration of a specific element in the semiconductor substrate is the highest in at least any region of the bonded interface and a region from the bonded interface to a vicinity of 15 nm.

13. The semiconductor substrate according to claim 12, wherein the concentration of the specific element at the bonded interface is 1×10¹⁹ atoms/cm³ to 2.0×10²⁰ atoms/cm³.

14. The semiconductor substrate according to claim 12 or 13, wherein the specific element in the semiconductor substrate has a high concentration in at least one of the bonded interface and a region from the bonded interface to a vicinity of 15 nm and in a region 40 nm to 60 nm away from the bonded interface.

15. The semiconductor substrate according to claim 12, wherein the first semiconductor substrate and the second semiconductor substrate are any one of silicon carbide (SiC), silicon (Si), carbon (C), gallium nitride (GaN), aluminum nitride (AlN), gallium oxide (Ga₂O₃), and diamond.

16. The semiconductor substrate according to claim 12, wherein the semiconductor substrate comprising a damaged layer in at least one of the bonded interface and a region from the bonded interface to a vicinity of 15 nm, wherein
at least one of silicon (Si), carbon (C), helium (He), neon (Ne), argon (Ar), xenon (Xe), hydrogen (H), nitrogen (N), phosphorus (P), boron (B), and aluminum (Al) is present in the damaged layer.

17. The semiconductor substrate according to claim 12, wherein the specific element is at least one of nitrogen (N), phosphorus (P), boron (B), and aluminum (Al).

18. The semiconductor substrate according to claim 12, wherein
the first semiconductor substrate is a SiC polycrystal substrate,
the second semiconductor substrate is a SiC single crystal substrate, and
a concentration of phosphorus at the bonded interface is 1×10¹⁹ atoms/cm³ to 2.0×10²⁰ atoms/cm³.
